# EUROPÄISCHE PATENTSCHRIFT

(11) **EP 0 575 789 B1**
(45) Veröffentlichungstag und Bekanntmachung des Hinweises auf die Patenterteilung: **29.09.1999**
(21) Anmeldenummer: 93108910.6
(22) Anmeldetag: 03.06.1993
(51) Int. Cl.: H01L 27/06, H01L 21/82

(54) **Monolithisch integrierter Millimeterwellenschaltkreis und Verfahren zu dessen Herstellung**
Monolithic millimetre-wave integrated circuit and method of its fabrication
Circuit intégré monolithique pour anoles millimétriques et son procédé ou fabrication

(30) Priorität: 15.06.1992 DE 4219523
(43) Veröffentlichungstag der Anmeldung: 29.12.1993
(73) Patentinhaber: DaimlerChrysler AG, 70567 Stuttgart (DE)
(72) Erfinder: Brugger, Hans, Dr. rer. nat., D-7913 Senden (DE)
(74) Vertreter: Fröhling, Werner Otto, Dr.

(56) Entgegenhaltungen:
- EP-A- 119 089
- EP-A- 287 793
- PATENT ABSTRACTS OF JAPAN, Vol. 12, No. 385 (E-668)(3232) 14. Oktober 1988; & JP-A-63 129 656 (FUJITSU LTD.), 2. Juni 1988
- Electronics Letters, Bd. 26, Nr. 6, 15. Maerz 1990, Stevenage GB, Seiten 384-385; ARCHER, J.A.: "Gallium Arsenide MBE Structure comprising Mixer Diodes and FETs for Monolithic Millimetre-wave Receivers"

## Beschreibung

Die Erfindung betrifft einen integrierten Schaltkreis nach dem Oberbegriff des Patentanspruchs 1.

Die Erfindung findet Verwendung in der Millimeterwellen-Kommunikationstechnik und Sensorik, sowie der Radartechnik, Verkehrstechnik und Satellitentechnik.

In Kommunikations- und Sensoriksystemen führt eine weitere Erhöhung der Arbeitfrequenzen in den Millimeterwellenbereich zu einer verbesserten Strahlcharakteristik und zu einer höheren Auflösung. Von besonderem Interesse sind dabei Frequenzen im Bereich der atmosphärischen Fenster bei 94 GHz, 140 GHz und 220 GHz für Kommunikationssysteme, sowie die durch Sauerstoff und Wasser verursachten Absorptionsbanden in den dazwischen liegenden Frequenzbereichen für kurzreichweitige Systeme. Dies erfordert jedoch integrierte Schaltkreise, die entsprechende Verstärkungs-, Rausch- und Mischereigenschaften im Millimeterwellenbereich aufweisen, sog. MMICs (monolithisch integrierte Millimeterwellenschaltungen). Die einzelnen Bauelemente müssen deshalb immer höhere Grenzfrequenzen mit geeignetem Hochfrequenzverhalten aufweisen.

Es ist bekannt, daß für die technologische Fertigung von elektronischen Bauelementen für hohe Arbeitsfrequenzen (Höchstfrequenzbauelemente) Halbleiterausgangsmaterialien verwendet werden, die mit epitaktischen Wachstumsmethoden (z.B. MBE-Verfahren, CVD-Verfahren) hergestellt werden. Durch die Epitaxie werden auf einem Substrat unterschiedliche, die Funktion des Bauelements bestimmende Schichten, abgeschieden und mit lithographischen Verfahren (Photo- und Elektronenstrahllithographie) und Ätzverfahren (naß- und trockenchemische Prozesse) strukturiert.

Ferner ist es für das GaAs-Materialsystem bekannt, halbisolierende Bereiche in vormals leitenden Schichten durch Beschuß mit Borionen oder Protonen und n-leitende Bereiche in vormals halb/isolierenden Schichten durch Beschluß mit Siliziumionen und anschließender Kurzzeitausheilung bei der Halbleiterfertigung zu erzeugen.

Die Entwicklungen in den letzten Jahren haben gezeigt, daß sich mit Heterostruktur-Feldeffekt-Transistoren (HFETs) die bisher höchsten Verstärkergrenzfrequenzen erreichen lassen. Für Anwendungen im Millimeterwellenbereich ist der HFET gegenüber herkömmlichen Bauelementen, insbesondere dem MESFET-Bauelement, überlegen, vorallem im Rauschverhalten und in den Hochfrequenzverstärkereigenschaften. Ferner ist der HFET aufgrund seiner physikalischen Funktionsweise für kryogene Anwendungen bis zu sehr tiefen Temperaturen einsetzbar.

GaAs-Schottkydioden haben für Arbeitsfrequenzen bis weit in den Submillimeterwellenbereich hinein die z.Zt. besten Mischereigenschaften für Raumtemperaturanwendungen (D.G. Garfield, R.J.Mattauch, and S. Weinreb: "RF Performance of a Novel Planar Millimeter-Wave Diode Incorporating an Etched Surface Channel", IEEE Transactions on Microwave Theory and Techniques 39 (1) 1991, pp. 1-5, und darin enthaltene Referenzen).

Durch einen monolithisch integrierten Aufbau eines elektronischen Systems lassen sich parasitäre Verluste, insbesondere an den Verbindungsstellen der verschiedenen Bauelemente minimieren. Ferner lassen sich die Montagekosten durch den geringeren Aufwand an hybrider Aufbautechnik deutlich senken.

Ein Verfahren zur planaren Herstellung von MMICs aus GaAs MESFETs und Schottkydioden für Arbeitsfrequenzen unterhalb 100 GHz ist aus A.Colquhoun, G.Ebert, J.Selders, B. Adelseck, J.M. Dieudonne, K.E. Schmegner, and W. Schwab: "A Fully Monolithic Integrated 60 GHz Receiver", Proceedings of the Galliumarsenide IC Symposium, 1989, San Diego, California, pp. 185-188, bekannt.

Ein Ansatz für die Integration von HFETs mit Schottkydioden in einer nicht-planaren Geometrie ist in W.J. Ho, E.A. Sovero, D.S. Deadin, R.D. Stein, G.J. Sullivan, and J.A. Higgens: "Monolithic Integration of HEMTs and Schottkydiodes for Millimeter Wave Circuits", Rec. of the IEEE GaAs Integrated Circuits Symposium, 1988, pp. 239-242, veröffentlicht. Dabei wird eine n⁺nn⁺ GaAs-Schichtenfolge für die Diode epitaktisch auf eine AlGaAs/GaAs-Schichtenfolge für den HFET gestapelt. Voraussetzung für die Realisierung höchster Diodengrenzfrequenzen ist jedoch ein sehr niedriger parasitärer Widerstand und eine geringe Kapazität die nur mit sehr dicken n+-Zuleitungsschichten (typischerweise mindestens im Bereich von 1µm) und einer aktiven Schicht mit einer Dicke zwischen 0,5µm und 1µm realisiert werden kann (siehe D.G. Garfield et al., IEEE Transactions on Microwave Theory and Techniques 39(1), 1991, pp.1-5). Dadurch kommt es bei der vorgeschlagenen Struktur zu einer unvermeidbar großen Höhendifferenz zwischen Diode und HFET. Die Nichtplanarität erschwert die technologische Herstellung der Schaltung erheblich.

Der Erfindung liegt die Aufgabe zugrunde, einen integrierten Schaltkreis für den Millimeterwellenbereich und ein Verfahren zu dessen Herstellung anzugeben, dessen Anordnung der Halbleiterbauelemente eine vereinfachte technische Herstellung ermöglicht. Die Aufgabe wird gelöst durch die im kennzeichnenden Teil des Patentanspruchs 1 angegebenen Merkmale. Verfahren zur Herstellung eines integrierten Schaltkreises nach Anspruch 1 sind in den Ansprüchen 6 und 13 definiert. Vorteilhafte Ausgestaltungen und/oder Weiterbildungen sind den Unteransprüchen zu entnehmen.

Die Erfindung wird anhand eines Ausführungsbeispiels und unter Bezugnahme auf schematische Zeichnungen näher erläutert.

In FIG. 1 ist der Halbleiterschichtaufbau für den im Ausführungsbeispiel angegebenen Schaltkreis dargestellt.

FIG. 2 zeigt eine Anordnung von Schottkydioden und HFET auf einem halbisolierenden Substrat.

Ein Vorteil der Erfindung besteht in der Kombination von HFET und Schottkydiode in integrierter Bauweise, da dadurch parasitäre Verluste insbesondere an den Verbindungsstellen der Bauelemente minimiert werden. Durch den erfindungsgemäßen Schichtaufbau für den integrierten Schaltkreis lassen sich die Diode und der Transistor unabhängig auf die gewünschten Eigenschaften optimieren.

Weiterhin ist vorteilhaft, daß durch die quasi-planare Anordnung von Schottkydiode und HFET eine vereinfachte und parallele Herstellung der Kontaktbereiche für beide Bauelemente in technologisch kompatibler Weise ermöglicht wird, insbesondere wird der Gate-Herstellungsprozeß für beide Bauelemente gleichzeitig durchgeführt. Vorzugsweise werden für den Schottkykontakt ein niederohmiger Pilz- bzw. T-Gatekontakt in einer Mehrfingeranordnung verwendet.

Mit auf halbisolierenden GaAs-Substraten aus III/V-Halbleiterverbindungen angeordneten pseudomorphen HFETs mit Potentialtöpfen aus InGaAs mit Grenzfrequenzen über 200 GHz und Schottkydioden mit Grenzfrequenzen weit im THz-Bereich werden Schaltkreise im Millimeterwellenbereich realisiert, mit denen rauscharme Millimeterwellen Empfänger Frontends in integrierter Form auf z.B. einem GaAs-Substrat mit Antenne, rauscharmem Vorverstärker, Diodenmischer, rauscharmem ZF-Verstärker, spannungskontrolliertem Varaktordioden HFET Oszillator und passiven Komponenten hergestellt werden.

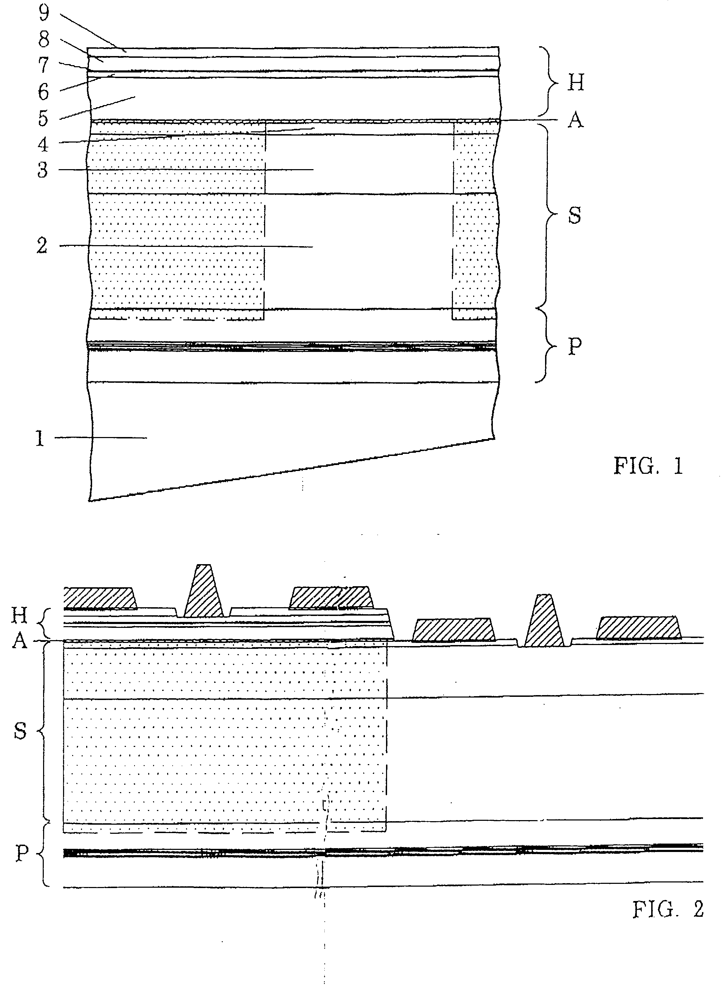

In einem Ausführungsbeispiel (FIG. 1) wird die Erfindung näher erläutert.

Als Substrat 1 wird eine halbisolierende GaAs-Scheibe verwendet. Mit Hilfe einer Epitaxiemethode, vorzugsweise Molekularstrahlepitaxie, wird in einem ersten Epitaxieschritt zuerst eine Pufferschicht P aus undotiertem GaAs-Material, AlGaAs/GaAs-Übergitter und undotiertem GaAs-Material hergestellt. Die Pufferschicht P besitzt z.B. eine Gesamtschichtdicke im Bereich von 0,5µm bis 1µm. Danach wird die mit Silizium dotierte GaAs-Schichtenfolge S für die Schottkydiode abgeschieden:
- eine dicke, niederohmige n⁺-Schicht 2 als vergrabene Diodenzuleitung mit einer hohen Dotierkonzentration, vorzugsweise im Bereich zwischen 5x10¹⁸cm⁻³ und 1x10¹⁹cm⁻³ zur Realisierung von Schichtwiderständen im Bereich von 10Ω/sq, mit einer beispielhaften Schichtdicke im Bereich von 0,4µm bis 0,6µm
- eine aktive Schicht 3, deren Dicke und Dotierkonzentration den geforderten Bauelementspezifikationen angepaßt wird, insbesondere zur Realisierung von kleinen Serienwiderständen und kleinen Sperrschichtkapazitäten, z.B. mit einer Schichtdicke im Bereich von 0,2µm bis 1µm und einer Dotierkonzentration im Bereich von 1 bis 5^{·}10¹⁷cm⁻³
- eine dünne, hoch dotierte Schicht 4, für gut leitende ohmsche Kontakte mit z.B. einer Schichtdicke von 30nm und einer Dotierkonzentration von mindestens 5^{·}10¹⁸cm⁻³.

Danach wird eine dünne, undotierte und Al-haltige Schicht A abgeschieden, vorzugsweise aus AlAs oder AlGaAs, die als Ätzstoppschicht für die technologische Herstellung, als Desorptionsstoppschicht für die Epitaxie und als rückseitige Elektronenbarriere für das HFET-Bauelement wirkt. Die Schicht A besitzt beispielsweise eine Schichtdicke von 10nm. Die Oberfläche wird abschließend mit einer dünnen, undotierten GaAs-Schicht passiviert, beispielsweise mit einer Schichtdicke von 50nm.

Die Epitaxiescheibe wird in einem weiteren ex-situ Technologieschritt mit einer Schicht, vorzugsweise einer dielektrischen Schicht (z.B. SiO₂, SiON), versehen und mit einem photolithographischen Verfahren werden Fenster geöffnet. Die hergestellte Maske dient als Implantationsmaske für eine selektive Isolationsimplantation. Anschließend wird die Scheibe mit der zuvor erwähnten Maskenschicht mit einem Element implantiert, vorzugsweise Sauerstoff, das aufgrund seines Gittereinbaus zusätzlich zur Defektisolation auch als elektronischer Isolator wirkt und dieses Verhalten bis zu hohen Temperaturen beibehält. Das Implantationsprofil wird so gewählt, daß die zuvor in den Fensterbereichen leitenden n⁺nn⁺-Schottkydiodenschichten wieder kompensiert werden und damit zusammen mit einem später durchzuführenden Ausheilschritt wieder halbisolierendes Material erzeugt wird. Die dielektrische Schicht wird durch Ätzung entfernt und die Scheibe für einen zweiten Epitaxieschritt vorbereitet. Durch diese Lateralstrukturierung werden in einem "Negativ-Verfahren" die selektiven und vergrabenen Bahngebiete für die spätere Schottkydiode erzeugt. Alternativ kann in einem "Positiv-Verfahren" durch selektive Si-Implantation und anschließendem Hochtemperatur-Ausheilprozeß eine vergrabene Leiterbahn im Substrat hergestellt werden. Anschließend können in einem Epitaxieverfahren die Halbleiterschichten für die nn⁺-Schottkydiode, die Schicht A und den HFET gewachsen werden. Mit dieser Variante wird der erste Epitaxieschritt nicht benötigt, jedoch werden nur deutlich niedrigere Schichtleitfähigkeiten erreicht und die Oberflächenmorphologie wird durch den Hochtemperaturausheilschritt verschlechtert im Vergleich zum "Negativ-Verfahren".

In einem weiteren Verfahren wird die Scheibe innerhalb der Epitaxieanlage auf eine Desorptionstemperatur, vorzugsweise über der Epitaxietemperatur aber unterhalb der Oberflächendegradationstemperatur, gefahren und die natürliche Oxidschicht und die Passivierungsschicht unter Arsendruck thermisch abgetragen. Die Schicht A dient als Desorptionsstopper. Dadurch wird in-situ eine mikroskopisch glatte Oberfläche der Schicht A für den 2. Epitaxieschritt freigelegt. Gleichzeitig werden Kristalldefekte ausgeheilt, das Implantat elektronisch aktiviert und halbisolierende, implantierte Bereiche erzeugt. Alternativ kann eine dünne Passivierungsschicht, beispielsweise 10nm gewählt werden und die Epitaxiescheibe wird nur auf eine Temperatur zur Desorption des natürlichen Oxids unter Arsenstückdruck gebracht. Dadurch wird die Scheibe lediglich niedrigen Temperaturen von typischerweise unterhalb 600°C ausgesetzt und die implantierten Bereiche weisen halbisolierendes Verhalten vorwiegend aufgrund von Defektisolation auf.

Anschließend wird die pseudomorphe HFET Schichtenfolge H abgeschieden, vorzugsweise aus einer undotierten GaAs Pufferschicht, einem pseudomorphen InGaAs Quantentopf, Spacerschicht, modulationsdotierter AlGaAs Schicht und abschließender, hochdotierter GaAs Deckschicht für die ohmschen Kontakte (FIG. 1). Die Schichtenfolge H zeichnet sich dadurch aus, daß die GaAs Pufferschicht direkt auf der Schicht A aufgebracht ist und deren Schichtdicke dünn gewählt ist, vorzugsweise im Bereich von weniger als 100nm. Dadurch wird die HFET Bauelementhöhe auf einen Bereich der Größenordnung 0,1µm begrenzt. Die rückseitige Schicht A wirkt aufgrund der großen Leitungsbanddiskontinuität zusätzlich zum InGaAs Quantentopf als Elektronenbarriere für heiße Ladungsträger im Kanal und führt zu einer Verbesserung im Ausgangsleitwert.

Alternativ kann auf den InGaAs Quantentopf in der HFET-Schichtenfolge verzichtet werden. Allerdings werden dann nicht so hohe Grenzfrequenzen und Ströme erreicht.

Die Dicken der hochdotierten GaAs Deckschicht und der aktiven GaAs Schicht der Diode sind so auf die Dicken der hochdotierten GaAs Deckschicht und der modulationsdotierten AlGaAs Schicht des HFET abgestimmt, daß der Gaterecessprozeß für beide Bauelemente gleichzeitig durchgeführt werden kann und die Bauelementspezifikationen erfüllt werden.

Die Schichtenfolge H besteht beispielsweise aus
- einer undotierten Pufferschicht 5 aus GaAs mit einer Schichtdicke von 40nm,
- einer undotierten InGaAs-Schicht 6 mit einer Schichtdicke von 10nm und einem In-Gehalt von 20%,
- einer undotierten GaAs/AlGaAs Heterostruktur-Spacerschicht 7 mit einem Al-Gehalt von 25% und einer Schichtdicke von 3nm,
- einer modulationsdotierten AlGaAs-Schicht 8 mit einer homogen oder pulsförmigen Dotierkonzentration von 3^{.}10¹⁸cm⁻² und einer Schichtdicke von 30nm,
- einer GaAs-Deckschicht 9 mit einer Dotierkonzentration von mindestens 5^{.}10¹⁸cm⁻³ und einer Schichtdicke von 30nm.

Für die Bauelementherstellung wird an den Stellen, die für Schottkydiodenbauelemente vorgesehen sind, die HFET Schichtenfolge mit Hilfe eines photolithografischen Verfahrens und mit einem selektiven Ätzprozeß entfernt, der an der Schicht A stoppt. Anschließend wird ein selektiver Ätzprozeß verwendet, der die Schicht A abträgt und an der GaAs Oberfläche der Diodenschichtenfolge S stoppt. Anschließend werden durch ein Photolithographieverfahren die ohmschen Kontaktbereiche für beide Bauelemente definiert und hergestellt. Mit z.B. einem Elektronenstrahllithographieverfahren werden für beide Bauelemente die Schottkykontaktbereiche definiert, die Recessgräben mit einem Ätzverfahren hergestellt und die Metallkontakte in einem Aufdampfverfahren realisiert.

Der HFET kann nicht nur wie im Ausführungsbeispiel angegeben als einseitig dotierter Feldeffekttransistor ausgebildet sein, sondern es ist auch ein beidseitig dotierter HFET einsetzbar, d.h. oberhalb und unterhalb der das zweidimensionale Elektronengas führenden Kanalschicht befindet sich eine hochdotierte Schicht.

Die Erfindung ist auch nicht auf die im Ausführungsbeispiel angegebenen Materialien beschränkt, sondern es können z.B. auch auf InP-Substraten basierende HFET- und Schottkydiodenschichtenfolgen oder auf Si-Substraten basierende SiGe HFET- und Schottkydiodenschichtenfolgen verwendet werden. Weiterhin ist es möglich, anstelle des n-modulationsdotierten HFET auch einen p-dotierten HFET zu verwenden.

## Patentansprüche

1. Integrierter Schaltkreis der eine auf einem Substrat aufgewachsene Halbleiterschichtenfolge, zumindest eine Schottkydiode sowie mindestens einen Heterostrukturfeldeffekttransistor (HFET) mit entsprechenden Kontaktbereichen enthält, dadurch gekennzeichnet,
- daß die Halbleiterschichtenfolge aus einer Schichtenfolge (S) für die Schottkydiode und eine darauf aufgewachsene, flach ausgelegte Schichtenfolge (H) für den HFET besteht,
- daß die Schichtenfolge (H) des HFET eine dünne Pufferschicht (5) besitzt,
- daß zwischen der Pufferschicht des HFET und der Schichtenfolge (S) der Schottkydiode eine undotierte Halbleiterschicht (A) eingebracht ist, die sowohl als Ätzstoppschicht, als Desorptionsstoppschicht und auch als Barriere für die Ladungsträger des HFET ausgebildet ist,
- daß sich Kontakte der Schottkydiode auf den Halbleiterschichten der Schottkydiode befinden und sich Kontakte des HFET auf den Halbleiterschichten des HFET befinden, und
- daß die Schottkydiode und der HFET lateral benachbart und quasi-planar angeordnet sind.

2. Integrierter Schaltkreis nach Anspruch 1, dadurch gekennzeichnet, daß das Substrat und die Halbleiterschichtenfolge aus III/V-Halbleitermaterial bestehen.

3. Integrierter Schaltkreis nach Anspruch 1, dadurch gekennzeichnet, daß die Arbeitsfrequenz des Schaltkreises im Millimeterwellenbereich liegt.

4. Integrierter Schaltkreis nach Anspruch 1, dadurch gekennzeichnet, daß die Schottkydiode aus GaAs aufgebaut ist.

5. Integrierter Schaltkreis nach Anspruch 1, dadurch gekennzeichnet, daß der HFET aus einer pseudomorphen Al-GaAs/InGaAs/GaAs-Schichtenfolge oder einer AlGaAs/GaAs-Schichtenfolge besteht.

6. Verfahren zur Herstellung eines integrierten Schaltkreises nach einem der vorhergehenden Ansprüche, dadurch gekennzeichnet,
- daß auf einem halbisolierenden Substrat (1) eine Halbleiterschichtenfolge (S) für die Schottkydiode epitaktisch aufgewachsen wird,
- daß anschließend eine undotierte Halbleiterschicht (A) abgeschieden wird, die als Ätzstoppschicht, als Desorptionsstoppschicht und als Ladungsträgerbarriere für den HFET ausgebildet ist,
- daß die undotierte Halbleiterschicht (A) mit einer dünnen undotierten Passivierungsschicht bedeckt wird,
- daß anschließend mit photolithographischen Verfahren auf der Oberfläche der Halbleiterschichtenfolge eine Maske hergestellt wird, die den Teil der Halbleiterschichtenfolge abdeckt, aus dem die Schottkydiode hergestellt wird,
- daß mit selektiver Isolationsimplantation in den Fensterbereichen der Maske das Halbleitermaterial der elektrisch leitenden Schottkydioden-Schichten (S) in halbisolierendes Material umgewandelt wird,
- daß anschließend die Maske und die Passivierungsschicht entfernt wird,
- daß in einem zweiten Epitaxie-Verfahren eine pseudomorphe Halbleiterschichtenfolge (H) für den HFET auf die undotierte Halbleiterschicht (A) aufgewachsen wird,
- daß in dem Bereich der Halbleiterschichtenfolge, aus dem die Schottkydiode hergestellt wird, die Schichtenfolge (H) des HFET selektiv weggeätzt wird,
- daß nachfolgend im Bereich der Schottkydiode die undotierte Halbleiterschicht (A) selektiv entfernt wird, und
- daß die Kontaktbereiche für Schottkydiode und HFET gleichzeitig hergestellt werden.

7. Verfahren nach Anspruch 6, dadurch gekennzeichnet, daß auf einem halbisolierenden GaAs-Substrat (1) eine Pufferschicht (P) aus einer undotierten GaAs-Schicht, einem Al-GaAs/GaAs-Übergitter und einer undotierten GaAs-Schicht mit einer Gesamtschichtdicke im Bereich von 0,5µm bis 1µm aufgewachsen wird, und daß auf die Pufferschicht (P) die Schichtenfolge (S) aus
- einer n⁺-dotierten GaAs-Schicht (2) mit einer Dotierkonzentration im Bereich von 5^{.}10¹⁸ bis 1^{.}10¹⁹cm⁻³ und einer Schichtdicke im Bereich von 0,4µm bis 0,6µm,
- einer n-dotierten GaAs-Schicht (3) mit einer Schichtdicke im Bereich von 0,2µm bis 1µm und einer Dotierkonzentration im Bereich von 1 bis 5^{.}10¹⁷cm⁻³
- eine n⁺-dotierten GaAs-Schicht (4) mit einer Dotierkonzentration von mindestens 5^{.}10¹⁸cm⁻³ und einer Schichtdicke von ca. 30nm
aufgewachsen wird.

8. Verfahren nach Anspruch 6, dadurch gekennzeichnet, daß die undotierte Halbleiterschicht (A) aus undotiertem AlAs oder AlGaAs mit einer Schichtdicke von ca. 10nm hergestellt wird.

9. Verfahren nach Anspruch 6, dadurch gekennzeichnet, daß die Schichtenfolge (H) für den HFET aus
- einer undotierten Pufferschicht (5) aus GaAs mit einer Schichtdicke von ca. 40nm,
- einer undotierten InGaAs-Schicht (6) mit einer Schichtdicke von ca. 10nm und einem In-Gehalt von ca. 20%,
- einer undotierten Spacerschicht (7) aus einer GaAs/AlGaAs-Heterostruktur mit einem Al-Gehalt von ca.25% und einer Schichtdicke von ca. 3nm,
- einer modulationsdotierten AlGaAs-Schicht (8) mit einer homogenen oder pulsförmigen Dotierkonzentration von ca. 3^{.}10¹⁸cm⁻³ und einer Schichtdicke von ca. 30nm,
- einer n⁺-dotierten GaAs-Deckschicht (9) mit einer Dotierkonzentration von mindestens 5^{.}10¹⁸cm⁻³ und einer Schichtdicke von ca. 30nm,
epitaktisch hergestellt wird.

10. Verfahren nach Anspruch 6, dadurch gekennzeichnet, daß die selektive Isolationsimplantation mit Sauerstoff durchgeführt wird.

11. Verfahren nach Anspruch 6, dadurch gekennzeichnet, daß die auf der Schicht (A) aufgebrachte Passivierungsschicht unter Arsendruck thermisch abgetragen wird.

12. Verfahren nach Anspruch 6, dadurch gekennzeichnet, daß die auf die undotierte Halbleiterschicht (A) aufgebrachte, dünne Passivierungsschicht nicht abgetragen wird und daß die Epitaxiescheibe bei einer Temperatur unter 600°C gehalten wird.

13. Verfahren zur Herstellung eines integrierten Schaltkreises nach einem der Ansprüche 1 bis 5, dadurch gekennzeichnet,
- daß in einem halbisolierenden Substrat durch selektive Si-Implantation und anschließenden Ausheilprozeß eine vergrabene n⁺-Leiterbahn hergestellt wird, und
- daß anschließend in einem Epitaxieprozeß eine aktive n⁻-Halbleiterschicht und eine n⁺-Kontaktschicht der Schottkydiode, die undotierte Halbleiterschicht (A) und die Schichtenfolge (H) für den HFET abgeschieden werden.

## Claims

1. Integrated circuit which comprises a semiconductor layer sequence grown on a substrate, at least one Schottky diode as well as at least one heterostructure field effect transistor (HFET) with appropriate contact regions, characterised in that
- the semiconductor layer sequence consists of a layer sequence (S) for the Schottky diode and a layer sequence (H), which is grown thereon and designed to be flat, for the HFET,
- the layer sequence (H) of the HFET has a thin buffer layer (5),
- an undoped semiconductor layer (A) is formed between the buffer layer of the HFET and the layer sequence (S) of the Schottky diode and is constructed not only as an etching stop layer and a desorption stop layer, but also as a barrier for the charge carrier of the HFET,
- contacts of the Schottky diode are disposed on the semiconductor layers of the Schottky diode and contacts of the HFET are disposed on the semiconductor layers of the HFET, and
- the Schottky diode and the HFET are arranged to be laterally adjacent and quasi-planar.

2. Integrated circuit according to claim 1, characterised in that the substrate and the semiconductor layer sequence consists of III/V semiconductor material.

3. Integrated circuit according to claim 1, characterised in that the operating frequency of the circuit lies in the millimetre wave range.

4. Integrated circuit according to claim 1, characterised in that the Schottky diode is built up from GaAs.

5. Integrated circuit according to claim 1, characterised in that the HFET consists of a pseudomorphic AlGaAs/lnGaAs/GaAs layer sequence or a AlGaAs/GaAs layer sequence.

6. Method of producing an integrated circuit according to one of the preceding claims, characterised in that
- a semiconductor layer sequence (S) for the Schottky diode is epitaxially grown on a semi-insulating substrate (1),
- subsequently an undoped semiconductor layer (A) is precipitated, which is constructed as an etching stop layer, as a desorption layer and as a charge carrier barrier for the HFET,
- the undoped semiconductor layer (A) is covered with a thin undoped passivating layer,
- subsequently a mask, which covers the part of the semiconductor layer sequence from which the Schottky diode is produced, is produced on the surface of the semiconductor layer sequence by photolithographic processes,
- the semiconductor material of the electrically conductive Schottky diode layers (S) are converted into semi-insulating material by selective insulation implantation in the window regions of the mask,
- subsequently the mask and the passivating layer are removed,
- a pseudomorphic semiconductor layer sequence (H) for the HFET is grown on the undoped semiconductor layer (A) in a second epitaxial process,
- the layer sequence (H) of the HFET is selectively etched away in the region of the semiconductor layer sequence from which the Schottky diode is produced,
- the undoped semiconductor layer (A) is then selectively removed in the region of the Schottky diode, and
- the contact regions for Schottky diode and HFET are produced simultaneously.

7. Method according to claim 6, characterised in that a buffer layer (P) consisting of an undoped GaAs layer, an AlGaAs/GaAs superlattice and an undoped GaAs layer with an overall thickness in the range of 0.5 microns to 1 micron is grown on a semi-insualting GaAs substrate (1) and that the layer sequence (S) consisting of
- an n⁺ doped GaAs layer (2) with a doping concentration in the range of 5·10¹⁸ to 1·10¹⁹ cm⁻³ and a layer thickness in the range of 0.4 microns to 0.6 microns,
- an n doped GaAs layer (3) with a layer thickness in the range of 0.2 microns to 1 a micron and a doping concentration in the range of 1 to 5·10¹⁷ cm⁻³, and
- an n⁺ doped GaAs layer (4) with a doping concentration of at least 5·10¹⁸cm⁻³ and a layer thickness of about 30 nanometres,
is grown on the buffer layer (P).

8. Method according to claim 6, characterised in that the undoped semiconductor layer (A) is produced from undoped AlAs or AlGaAs with a layer thickness of about 10 nanometres.

9. Method according to claim 6, characterised in that the layer sequence (H) for the HFET is epitaxially produced from
- an undoped buffer layer (5) consisting of GaAs with a layer thickness of about 40 nanometres,
- an undoped InGaAs layer (6) with a layer thickness of about 10 nanometres and an In content of about 20%,
- an undoped spacer layer (7) consisting of a GaAs/AlGaAs heterostructure with an Al content of about 25% and a layer thickness of about 3 nanometres,
- a modulation-doped AlGaAs layer (8) with a homogeneous or pulse-shaped doping concentration of about 3·10¹⁸ cm⁻³ and a layer thickness of about 30 nanometres, and
- an n⁺ doped GaAs covering layer (9) with a doping concentration of at least 5·10¹⁸ cm⁻³ and a layer thickness of about 30 nanometres.

10. Method according to claim 6, characterised in that the selective insulation implantation is carried out with oxygen.

11. Method according to claim 6, characterised in that the passivating layer applied to the layer (A) is thermally removed under arsenic pressure.

12. Method according to claim 6, characterised in that the thin passivating layer applied to the undoped semiconductor layer (A) is not removed and that the epitaxial wafer is kept at a temperature under 600°C.

13. Method of producing an integrated circuit according to one of claims 1 to 5, characterised in that
- a buried n⁺ conductor track is produced in a semi-insulating substrate by selective Si implantation and subsequent curing process, and
- subsequently an active n⁻ semiconductor layer and an n⁺ contact layer of the Schottky diode, the undoped semiconductor layer (A) and the layer sequence (H) for the HFET are precipitated in an epitaxial process.

## Revendications

1. Circuit intégré qui contient sur une succession de couches semiconductrices développées sur un substrat, au moins une diode de Schottky ainsi qu'au moins un transistor à effet de champ à hétérostructure (HFET) avec des zones de contact correspondantes, caractérisé en ce que
- la succession de couches semiconductrices se compose d'une succession de couches (S) pour les diodes de Schottky et d'une succession de couches planes, développée au-dessus (H) pour le HFET,
- en ce que la succession de couches (H) du HFET possède une couche intermédiaire mince (5),
- en ce qu'entre la couche intermédiaire du HFET et la succession de couches (S) de la diode de Schottky est déposée une couche semiconductrice non dopée (A), qui est réalisée en tant que couche d'arrêt de gravure, en tant que couche d'arrêt de désorption et également en tant que barrière pour les porteurs de charge du HFET, en ce que les contacts de la diode de Schottky se trouvent les couches semiconductrices de la diode de Schottky et les contacts du HFET se trouvent sur les couches semiconductrices du HFET, et
- en ce que la diode de Schottky et le HFET adjacents latéralement sont disposés de façon quasi-planaire.

2. Circuit intégré selon la revendication 1, caractérisé en ce que le substrat et la succession de couches semiconductrices sont en matériau semiconducteur III/V.

3. Circuit intégré selon la revendication 1, caractérisé en ce que la fréquence de travail du circuit se trouve dans la plage des ondes millimétriques.

4. Circuit intégré selon la revendication 1, caractérisé en ce que la diode de Schottky est en GaAs.

5. Circuit intégré selon la revendication 1, caractérisé en ce que le HFET se compose d'une succession de couches AlGaAs/InGaAs/GaAs pseudomorphe ou d'une succession de couches AlGaAs/GaAs.

6. Procédé de fabrication d'un circuit intégré selon l'une quelconque des revendications précédentes, caractérisé en ce que,
- sur un substrat semi-isolant (1), on fait croître par épitaxie, une succession de couches semiconductrices (S) pour la diode de Schottky,
- ensuite, une couche semiconductrice non dopée (A) est déposée, qui est réalisée en tant que couche d'arrêt de gravure, en tant que couche d'arrêt de désorption et en tant que barrière de porteurs de charge pour le HFET,
- la couche semiconductrice non dopée (A) est recouverte d'une couche de passivation mince non dopée,
- ensuite à l'aide d'un procédé photolithographique, est réalisé, sur la surface de la succession de couches semiconductrices, un masque qui recouvre la partie de la succession de couches semiconductrices, à partir de laquelle est réalisée la diode de Schottky,
- par implantation d'isolement sélective dans les zones de fenêtre du masque, le matériau semiconducteur des couches de diodes Schottky électriquement conductrices (S) est converti en un matériau semi-isolant,
- ensuite le masque et la couche de passivation sont éliminés,
- à l'aide d'un second procédé d'épitaxie, on fait croître une succession de couches semiconductrices pseudomorphe (H) pour le HFET sur la couche semiconductrice non dopée (A),
- dans la région de la succession de couches semiconductrices, à partir de laquelle est réalisée la diode de Schottky, la succession de couches (H) du HFET est sélectivement éliminée par gravure,
- ensuite dans la région de la diode de Schottky, la couche semiconductrice non dopée (A) est éliminée sélectivement, et
- les régions de contact pour la diode de Schottky et le HFET sont réalisées simultanément.

7. Procédé selon la revendication 6, caractérisé en ce que, sur un substrat de GaAs semi-isolant (1), est déposée une couche intermédiaire (P) se composant d'une couche GaAs non dopée, d'une couche de recouvrement AlGaAs/GaAs et d'une couche GaAs non dopée d'une épaisseur globale comprise entre 0,5 pm et 1 µm, et en ce qu'on fait croître sur la couche intermédiaire (P) la succession de couches (S) se composant
- d'une couche GaAs dopée n⁺ (2) avec une concentration de dopage comprise entre 5·10¹⁸ et 1.10¹⁹cm⁻³ et une épaisseur comprise entre 0,4 µm et 0,6 µm,
- d'une couche GaAs dopée n (3) avec une épaisseur comprise entre 0,2 µm et 1 µm et une concentration de dopage comprise entre 1 et 5.10¹⁷cm⁻³
- d'une couche GaAs dopée n⁺ (4) avec une concentration de dopage d'au moins 5.10¹⁸cm⁻³ et une épaisseur d'environ 30 nm.

8. Procédé selon la revendication 6, caractérisé en ce que la couche semiconductrice non dopée (A) est constituée de AlAs ou AlGaAs non dopé avec une épaisseur d'environ 10 nm.

9. Procédé selon la revendication 6, caractérisé en ce que la succession de couches (H) pour le HFET se composant
- d'une couche intermédiaire non dopée (5) en GaAs avec une épaisseur d'environ 40 nm,
- d'une couche InGaAs non dopée (6) avec une épaisseur d'environ 10 nm et une teneur en In d'environ 20%,
- d'une couche d'espacement non dopée (7) en une hétérostructure GaAs/AlGaAs avec une teneur en Al d'environ 25% et une épaisseur d'environ 3 nm,
- d'une couche AlGaAs dopée de façon modulée (8) avec une concentration de dopage homogène ou pulsatoire d'environ 3.10¹⁸cm⁻³ et une épaisseur d'environ 30 nm,
- d'une couche de recouvrement GaAs dopée n⁺ (9) avec une concentration de dopage d'environ 5.10¹⁸cm⁻³ et une épaisseur d'environ 30 nm,
est obtenue par épitaxie.

10. Procédé selon la revendication 6, caractérisé en ce que l'implantation d'isolement sélectif est effectuée avec de l'oxygène.

11. Procédé selon la revendication 6, caractérisé en ce que la couche de passivation déposée sur la couche (A) est éliminée thermiquement sous pression d'arsenic.

12. Procédé selon la revendication 6, caractérisé en ce que la couche de passivation mince déposée sur la couche semiconductrice non dopée (A) n'est pas éliminée et en ce que le disque épitaxial est maintenu à une température inférieure à 600°C.

13. Procédé de fabrication d'un circuit intégré selon l'une quelconque des revendications 1 à 5, caractérisé,
- en ce que, dans un substrat semi-isolant, par implantation sélective de Si et ensuite procédé de cicatrisation, est réalisée une piste conductrice n⁺ enterrée, et
- en ce qu'ensuite, par un processus d'épitaxie, sont déposées une couche semiconductrice n⁻ active et une couche de contact n⁺ de la diode de Schottky, la couche semiconductrice non dopée (A) et la succession de couches (H) pour le HFET.
